# EUROPEAN PATENT APPLICATION

(11) **EP 3 726 292 A1**
(43) Date of publication of application: **21.10.2020**
(21) Application number: 18888674.1
(22) Date of filing: 30.10.2018
(51) Int. Cl.: G03F 1/64

(54) **PELLICLE FRAME BODY FOR FLAT PANEL DISPLAY (FPD) AND MANUFACTURING METHOD THEREFOR**

(30) Priority: 12.12.2017 JP 2017237595
(71) Applicant: Nippon Light Metal Company, Ltd., Tokyo 1058681 (JP)
(72) Inventor: IIZUKA, Akira, Shizuoka-shi Shizuoka 4213203 (JP); NAKANO, Koichi, Shizuoka-shi Shizuoka 4213203 (JP); KOMURA, Naoto, Shizuoka-shi Shizuoka 4213203 (JP); YATSUKURA, Masato, Tokyo 105-8681 (JP); OKABATAKE, Yuto, Shizuoka-shi Shizuoka 4213297 (JP)
(74) Representative: Mewburn Ellis LLP
(86) International application number: PCT/JP2018/040227
(87) International publication number: WO 2019/116755

(57) **Abstract**

To provide a pellicle frame for FPD (flat Panel display), which can maintain the rigidity required for a pellicle for a large FPD (flat Panel display) even if the cross-sectional area of the frame is reduced and can enlarge the inner dimensions of the frame by reducing the cross-sectional area, and has high dimensional accuracy and flatness, and an efficient manufacturing method thereof. The present invention provides a pellicle frame for FPD (flat panel display) composed of an extruded material of an aluminum alloy powder sintered body containing Si:20 to 40 % by mass, Mg:0.2 to 1.2 % by mass, Cu:2 % by mass or less, Fe:2 % by mass or less, Cr:0.4 % by mass or less, the balance being Al and unavoidable impurities to provide.

## Description

### TECHNICAL FIELD

The present invention relates to a frame of a pellicle for preventing contaminants from adhering to a photomask or a reticle used in a lithography process and a manufacturing method thereof in the manufacture of FPD (flat panel display), in particular, to a pellicle frame for a large FPD (flat panel display) and a manufacturing method thereof.

### BACKGROUND OF THE INVENTION

Semiconductor devices such as LSI and ultra LSI and FPD (flat panel display) panels are patterned by irradiating a semiconductor wafer or FPD (flat panel display) original plate with light (pattern formation by lithography). Here, the pattern is not transferred well because the dust absorbs and/or reverses light when using an exposure master plate to which dust is attached (e.g., pattern deformation or edge unclearness). As a result, the quality and appearance of the semiconductor device and FPD (flat panel display) panel is impaired, there is a problem that a decrease in performance and manufacturing yield occurs.

For this reason, the lithography process is usually performed in a clean room, but since it is impossible to completely prevent the adhesion of dust to the exposure master plate even in the environment, it is common that a pellicle for dust protection is provided on the surface of the exposure master plate. The pellicle is composed of a pellicle frame and a pellicle film stretched on the pellicle frame, and is installed so as to surround a pattern area formed on the surface of the exposure master plate. If the focus is aligned on the pattern of the exposure master plate during lithography, even if dust adheres to the pellicle film, the dust does not affect the transfer.

Here, although the conventional pellicle for general semiconductors was about 150 mm square even large, with the recent enlargement of the FPD (flat panel display), the size of the pellicle is also increasing, and a pellicle frame having a size exceeding 1000 mm square is also required, for example. In addition to high dimensional accuracy and flatness, the pellicle frame is required to have a strength that does not deform due to the tension of the pellicle film, and it has become difficult to satisfy these requirements with the enlargement of the pellicle frame.

In this regards, for example, in Patent Document 1 (JP-A-2009-3111), there is disclosed a pellicle frame made of an aluminum alloy having a composition containing, in mass%, Mg: more than 3.5 % and 5.5 % or less, further one or two of Ti:0.005 to 0.15 %, B:0.0005 to 0.05 %, and Fe:0.15 % or less, Si: with the balance being Al and unavoidable impurities, wherein the total area ratio in the field of view of the crystallized material observed is 5 % or less, and the diameter of the largest crystallized material observed has a structure of 3 µm or less in the circle equivalent diameter in the tissue observation by a scanning electron microscope of 10000 times of the aluminum alloy.

In the pellicle frame described in Patent Document 1, by using 5000 based aluminum alloy having relatively high Mg content and making its tissue with less crystallized matter for the material of the pellicle frame, it is possible to provide an aluminum alloy pellicle frame capable of suppressing the occurrence of white point defects, in addition, securing the rigidity even relatively thin, and enlarging corresponding to a significant increase in size of the thin television.

Further, in Patent Document 2 (JP-A-2006-284927), a frame of an alcohol, a reinforcement member consisting of a material with a greater elastic coefficient than the frame, a support frame comprising a support frame, the reinforcement member is embedded in an embedded concave formed in the frame, the support frame is disclosed.

In the support frame for pellicle described in Patent Document 2, since the bending rigidity and shear rigidity than when constituted only with a frame body made of aluminum alloy is increased, it is difficult to flex and distortion occur even when enlarged. Moreover, since the structure in which the reinforcing member is embedded in the embedded recess formed in the frame body, it is possible to integrate the frame and the reinforcing member easily and reliably.

### PRIOR ART

### [Patent document]

[Patent Document 1] Japanese Unexamined Patent Application Publication No. 2009-3111(JP-A-2009-3111)
[Patent Document 2] Japanese Unexamined Patent Application Publication No. 2006-284927(JP-A-2006-284927)

### SUMMARY OF THE INVENTION

### PROBLEM TO BE SOLVED BY THE INVENTION

However, even the pellicle frame described in Patent Document 1, it is difficult to realize high dimensional accuracy, flatness, Young's modulus and strength, etc. required for the pellicle frame used in the FPD (flat panel display) of which the panel enlargement is rapidly advancing. In particular, in recent years, where it has been desired to enlarge the inner dimensions of the pellicle frame in order to maximize the exposure area, it was impossible to guarantee sufficient rigidity when the frame is thinned.

Further, in the pellicle support frame described in Patent Document 2, it is necessary to integrate or the like of the formation and the reinforcing member of the embedded recess to the frame, the manufacturing process becomes complicated and expensive. In addition, the reinforcing member, since the use of a dissimilar material such as iron or titanium having a higher elastic modulus than the frame, it is difficult to sufficiently ensure the processing accuracy and reliability.

In view of the problems in the prior art as described above, an object of the present invention is to provide a pellicle frame for FPD (flat panel display), which can maintain the stiffness required for the pellicle for a large FPD (flat panel display) even when the cross-sectional area of the frame is reduced, enlarge the inner dimension of the frame by reducing the cross-sectional area, and have a high dimensional accuracy and flatness, and to provide an efficient manufacturing method thereof.

### MEANS TO SOLVE THE PROBLEMS

The present inventors have, in order to achieve the above purpose, intensive research on the pellicle frame for FPD (flat panel display) and the manufacturing method thereof and, as the result, have found that it is extremely effective to use the extruded material of an aluminum alloy powder sintered body having a specific composition and reached the present invention.

That is, the present invention provides a pellicle frame for FPD (flat panel display) comprising an extruded material of an aluminum alloy powder (or powder sintered body), which contains Si:20 to 40 % by mass, Mg:0.2 to 1.2 % by mass, Cu:2 % by mass or less, Fe:2 % by mass or less, Cr:0.4 % by mass or less, the balance being Al and unavoidable impurities.

The pellicle frame for FPD (flat panel display) of the present invention, since it is constituted by an extruded material of the aluminum alloy powder sintered body of the above composition range, has a high Young's modulus compared to 7000 series (Al-Zn-Mg series) aluminum alloy, 6000 series (Al-Mg-Si series) aluminum alloy and 5000 series (Al-Mg series), which are used conventionally as materials for the pellicle frame.

In particular, Si contributes to the improvement of Young's modulus by crystallizing as Si phase in the Al matrix and, in addition, has the effect of lowering the thermal expansion coefficient as well as improving the wear resistance. In the pellicle frame for FPD (flat panel display) of the present invention, by setting the Si content to 20 % by mass or more, high Young's modulus, excellent wear resistance and low thermal expansion coefficient can be realized and, by setting the Si content to 40 % by mass or less, decrease in workability and decrease in strength and toughness due to Si phase can be suppressed. Incidentally, more preferable Si content is 24 to 28 % by mass.

Further, in the pellicle frame for FPD (flat panel display) of the present invention, it is preferable that the extruded materials are integrated with each other by friction stir welded portion. In order to constitute a pellicle frame by using the extruded materials of the aluminum alloy powder sintered body, it is indispensable to weld the extruded materials to each other. By integrating the extruded materials to each other by friction stir welded portion which is a solid-phase welding with relatively low welding temperature, it is possible to achieve welding without remarkable distortion and without strength reduction or the like.

When welding the extruded materials to each other using a melt welding such as arc welding or laser welding, the welded portion becomes a rapidly solidified structure and the difference in mechanical and thermal properties between the welded portion and the base material becomes large and, then, it is difficult to use in pellicle frame which is required to have high dimensional accuracy and reliability etc. In addition, although small pore defects may be formed in the welded portion in the melt welding, even very small defects in the pellicle frame occurs a serious problem. In contrast thereto, in addition that the distortion of the material to be welded by friction stir welding is extremely small, the welded portion (stirred portion) has a recrystallized structure basically without melt solidification and the difference between the welded portion and the base material can be relatively small.

Further, in the pellicle frame for FPD (flat panel display) of the present invention, it is preferable that the Young's modulus of the frame is 80 GPa or more. By making the Young's modulus of the frame 80 GPa or more, even a pellicle frame for a large FPD (flat panel display) can sufficiently ensure rigidity, and the frame can be made thinner than a conventional pellicle frame.

Further, in the FPD (flat panel display) pellicle frame of the present invention, it is preferable that the length of the short side is 330 mm or more and the length of the long side is 430 mm or more. Since the pellicle frame for FPD (flat panel display) of the present invention is composed of an extruded materials of aluminum alloy powder sintered body having high Young's modulus and has sufficient rigidity, it can be used as a pellicle frame even when the frame is enlarged.

Furthermore, in the pellicle frame for FPD (flat panel display) of the present invention, it is preferably composed of four of the extruded materials having substantially the same shape and size. By unifying the shape and size of the extruded materials constituting the pellicle frame, variations in quality between the extruded materials can be suppressed and the positions of the friction stir welded portions can also be uniformly arranged and, therefore, various characteristics of the pellicle frame can be homogenized.

In addition, the present invention provides, a method of manufacturing a pellicle frame for FPD (flat panel display) characterized comprising;
a first step of sintering aluminum alloy powder containing Si:20 to 40 % by mass, Mg:0.2 to 1.2 % by mass, Cu:2 % by mass or less, Fe:2 % by mass or less, Cr:0.4 % by mass or less, the balance being Al and unavoidable impurities to obtain an aluminum alloy powder sintered body,
a second step of extruding the aluminum alloy powder sintered body to obtain an extruded material, and
a third step of friction stir welding the extruded materials to each other to obtain a frame.

In the manufacturing method of the pellicle frame for FPD (flat panel display) of the present invention, by welding to each other the extruded materials of the aluminum alloy powder sintered body by friction stir welding, it is possible to achieve welding without significant distortion and without strength reduction or the like. Further, it is possible to suppress the occurrence of minute pore defects or the like in the welded portion. In addition, it is possible to reduce the difference between the welded portion and the regions other than the welded portion as compared with the case of using general melt welding.

Further, in case of the welding of the extruded materials of the aluminum alloy powder sintered body, it is possible to use a welding tool made of a relatively inexpensive hot work tool steel, for example. Since there is no need for an external heat source or the like in the welding process, it is possible to achieve a simple and inexpensive welding.

Further, in the method of manufacturing a pellicle frame for FPD (flat panel display) of the present invention, it is preferable that the length of the short side of the frame is 330 mm or more and the length of the long side is 430 mm or more, after the cutting process. In the method of manufacturing a pellicle frame body for FPD (flat panel display) of the present invention, the extruded materials of the aluminum alloy powder sintered body having a high Young's modulus is welded by friction stir welding which is a solid state welding. Therefore, even when the plate width is reduced as well as the frame is enlarged, it is possible to obtain a good frame.

Further, in the method of manufacturing a pellicle frame for FPD (flat panel display) of the present invention, it is preferable to constitute the frame with four of the extruded materials having substantially the same shape and size, in the third step. By unifying the shape and size of the extruded materials constituting the pellicle frame body, it is possible to improve the workability of extrusion and friction stir welding, it is possible to reduce the manufacturing cost.

Furthermore, in the manufacturing method of the FPD (flat panel display) pellicle frame of the present invention, it is preferable to perform the friction stir welding by the positional control of the welding tool. As the main control method of friction stir welding, there are positional control, load control and torque control of the tool. In case of aluminum alloy having small plastic deformation resistance compared with steel or the like, it is possible to accurately control the position (depth) of the welded portion (stirred portion) by using the position control. In the pellicle frame for FPD (flat panel display), although the formation of the unwelded portion in the rear surface of the welded portion becomes a serious problem, it is possible to completely suppress the formation of the unwelded portion by appropriately performing friction stir welding using the positional control.

### EFFECT OF THE INVENTION

In accordance with the present invention, it is possible to maintain the rigidity required for a pellicle for a large FPD (flat panel display) even when the cross-sectional area of the frame is reduced, it is possible to enlarge the inner dimensions of the frame by reducing the cross-sectional area, and it is possible to provide a pellicle frame for FPD (flat panel display) having a high dimensional accuracy and flatness and an efficient manufacturing method thereof.

### BRIEF DESCRIPTION OF THE DRAWINGS

Fig. 1 is a perspective view of a pellicle frame for FPD (flat panel display) of the present invention.
Fig. 2 is a C-C' cross-sectional view of a pellicle frame 1 for FPDs (flat panel displays).
Fig. 3 is a process flow of a method of manufacturing a pellicle frame for FPD (flat panel display) of the present invention.
Fig. 4 is an example of the arrangement of the extruded materials when subjected to friction stir welding.
Fig. 5 is a schematic diagram of a frame obtained by applying friction stir welding to the extruded material 2.
Fig. 6 is an overview photograph of the frame after friction stir welding in Example.
Fig. 7 is an overview photograph of a pellicle frame for FPD (flat panel display) in Example.
Fig. 8 is an enlarged photograph of the welded portion of the pellicle frame for FPD (flat panel display) in Example.
Fig. 9 is a horizontal hardness distribution of the cross-section of the welded portion of the pellicle frame for FPD (flat panel display) in Example.
Fig. 10 is a horizontal hardness distribution of the cross-section of the welded portion of the pellicle frame for FPD (flat panel display) in Comparative Example.

### DETAILED DESCRIPTION OF THE INVENTION

Hereinafter, exemplary embodiments of a pellicle frame for FPD (flat panel display) and a manufacturing method thereof of the present invention will be described in detail with reference to the figures, but the present invention is not limited thereto. In the following description, the same or corresponding components are denoted by the same reference numerals, and a repetitive description may be omitted. In addition, since the figures are for conceptually explaining the present invention, the dimensions and ratios of the components shown in the drawings may differ from actual ones.

### 1. Pellicle frame for flat panel displays (FPDs)

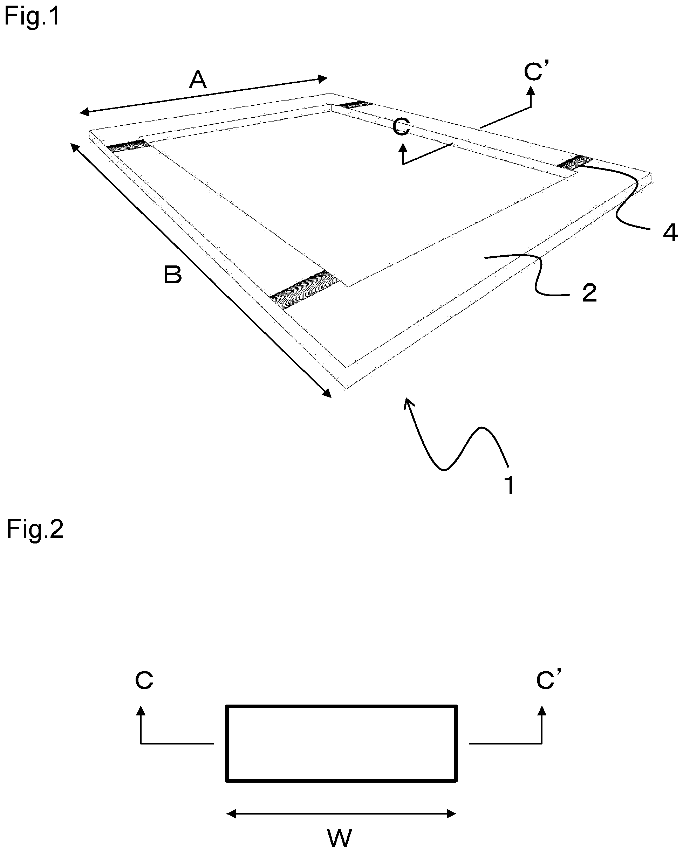

Fig. 1 shows a perspective view of a pellicle frame for FPD (flat panel display) of the present invention. The pellicle frame 1 for FPD (flat panel display) is composed of extruded materials of an aluminum alloy powder sintered body containing Si:20 to 40 % by mass, Mg:0.2 to 1.2 % by mass, Cu:2 % by mass or less, Fe:2 % by mass or less, Cr:0.4 % by mass or less, the balance being Al and unavoidable impurities, and has a high Young's modulus compared with 7000 series (Al-Zn-Mg series) aluminum alloy, 6000 series (Al-Mg-Si series) aluminum alloy and 5000 series (Al-Mg series) aluminum alloy, each conventionally used as a material of the pellicle frame. Hereinafter, the limiting reason for each additive element.

### (1) Si

Si contributes to the improvement of Young's modulus by crystallizing as Si phase in the Al matrix and, additionally, has the effect of lowering the thermal expansion coefficient as well as improving the wear resistance. In the FPD (flat panel display) pellicle frame of the present invention, by setting Si content to 20 % by mass or more, high Young's modulus, excellent wear resistance and low thermal expansion coefficient can be realized, and, by setting Si content to 40 % by mass or less, a decrease in workability and a decrease in strength and toughness due to coarsening of the Si phase can be suppressed. Incidentally, more preferable Si content is 24 to 28 % by mass.

### (2) Mg

The Mg content is 0.2 to 1.2 % by mass. By setting the Mg content in this range, it is possible to improve the strength by precipitation strengthening. (Precipitation strengthening by Mg₂Si, Al₂CuMg) Incidentally, more preferable Mg content is 0.55 to 0.90 % by mass.

### (3) Cu

The Cu content is 2 % by mass or less. By setting the Cu content in this range, it is possible to improve the strength by precipitation strengthening as well as the above Mg. (Precipitation strengthening by Mg₂Si, Al₂CuMg) It also contributes to Young's modulus improvement and corrosion resistance improvement. If more than 2 % by mass, the anodic oxide film property is lowered. Incidentally, more preferable Cu content is 0.11 to 0.30 % by mass.

### (4) Fe

The Fe content is 2 % by mass or less. By setting the Fe content in this range, it contributes to Young's modulus improvement, corrosion resistance improvement. When more than 2 % by mass, elongation, thermal conductivity, extrusion is reduced. Incidentally, more preferable Fe content is 0.7 % by mass or less.

### (5) Cr

The Cr content is Cr:0.4 % by mass or less. By setting the Cr content in this range, the crystal is refined, contributing to improvement of toughness. Incidentally, more preferable Cr content is 0.03 to 0.26 % by mass.

### (6) Al

In addition to the components of (1)-(5), the balance consists essentially of Al. As the other components, unavoidable impurities can be contained.

The pellicle frame 1 for FPD (flat panel display) is constituted by the extruded material 2 of the aluminum alloy powder sintered body and four extruded material 2 are integrated by the friction stir welded portion 4. Although shown exaggerating the region of the friction stir welded portion 4 in FIG. 1, in the pellicle frame 1 for FPD (flat panel display) obtained by performing cutting process, there is no large difference in appearance between the friction stir welded portion 4 and other regions. Here, the pellicle frame 1 for FPD (flat panel display) is preferably composed of four extruded material 2 having substantially the same shape and size. By unifying the shape and size of the extruded material 2 constituting the pellicle frame 1 for FPD (flat panel display), it is possible to suppress variations in quality between the extruded material 2, in addition, it is possible to uniformly arrange the friction stir welded portions 4, and it is possible to homogenize various characteristics of the pellicle frame 1 for FPD (flat panel display).

Further, the friction stir welded portions 4 and the extruded material 2 formed by friction stir welding can have relatively close mechanical properties, and the pellicle frame 1 for FPD (flat panel display) has a uniform mechanical properties as a whole. Here, the Vickers hardness of the friction stir welded portions 4 and the heat-affected zone in the vicinity of the friction stir welded portions 4 is preferably 70 to 130 % of the extruded material 2 (a region other than the friction stir welded portions 4).

The Young's modulus of the extruded material 2 is preferably 80 GPa or more. By making the Young's modulus of the extruded material 2 80 GPa or more, the rigidity can be sufficiently secured even in a pellicle frame for a large FPD (flat panel display), and the frame can be made thinner than a conventional pellicle frame. Incidentally, more preferable Young's modulus of the extruded material 2 is 85 GPa or more.

Further, it is preferable that the length of the short side of the FPD (flat panel display) for pellicle frame 1 (Ain FIG. 1) is 330 mm or more and the length of the long side (B in FIG. 1) is 430 mm or more. Since the pellicle frame 1 for FPD (flat panel display) is composed of the extruded material 2 of the aluminum alloy powder sintered body having a high Young's modulus, it can be sufficiently used as a pellicle frame even if the frame is enlarged.

Fig. 2 shows C-C' cross-sectional view of the pellicle frame 1 for FPDs (flat panel displays). The maximum width of the frame of the FPD (flat panel display) pellicle frame 1 (W in FIG. 2) is preferably 6 mm or less, and more preferably 5 mm or less. Since the pellicle frame 1 for FPD (flat panel display) is composed of the extruded material 2 of the aluminum alloy powder sintered body having a high Young's modulus, it is possible to secure the rigidity even if the frame width is reduced. Here, it is possible to suppress the exposure failure in the vicinity of the frame body by setting the maximum width of the frame to 6 mm or less, and it is possible to further enlarge the inner dimension of the pellicle frame 1 for FPD (flat panel display) by setting the maximum width of the frame to 5 mm or less.

The cross-sectional shape of the pellicle frame 1 for FPD (flat panel display) is not particularly limited to the extent that does not impair the effect of the present invention and can have a variety of conventionally known shapes, but quadrilateral shape in which the upper and lower sides are parallel is preferable. A width for stretching a pellicle film is required on the upper side of the pellicle frame 1 for FPD (flat panel display), and a width for providing an adhesive layer for adhesion to be adhered to the exposure master plate is required on the lower side.

The flatness of the pellicle frame 1 for FPD (flat panel display) is preferably 150 µm or less, more preferably 100 µm or less. By improving the flatness of the pellicle frame 1 for FPD (flat panel display), it is possible to reduce the amount of deformation of the pellicle frame 1 for FPD (flat panel display) when the pellicle is adhered pasted on the exposure master plate. Incidentally, the above flatness can be calculated by measuring the height at a total of eight points of the center four points of each corner 4 points and four sides of the pellicle frame 1 for FPD (flat panel display) to calculate a virtual plane and, then, by subtracting the lowest distance of a point from the virtual plane from the highest distance of a point from the virtual plane to obtain a difference as the flatness.

Further, by using the pellicle frame 1 for FPD (flat panel display), it is possible to constitute various pellicles. For example, if a transparent pellicle film is provided on to cover the upper surface of the pellicle frame 1 for FPD (flat panel display), an adhesive layer is formed on the lower surface of the pellicle frame 1 for FPD (flat panel display), and a protective film is provided on to cover the lower surface of the adhesive layer releasably, it is difficult to occur distortion or the like even when enlarged. Incidentally, it is possible to blacken the pellicle frame 1 for FPD (flat panel display) by various surface treatments or surface coatings conventionally known and, thereby, it is possible to avoid problems such that reflection of light during exposure makes the transfer pattern unclear.

### 2. Method of manufacturing a pellicle frame for FPD (flat panel display)

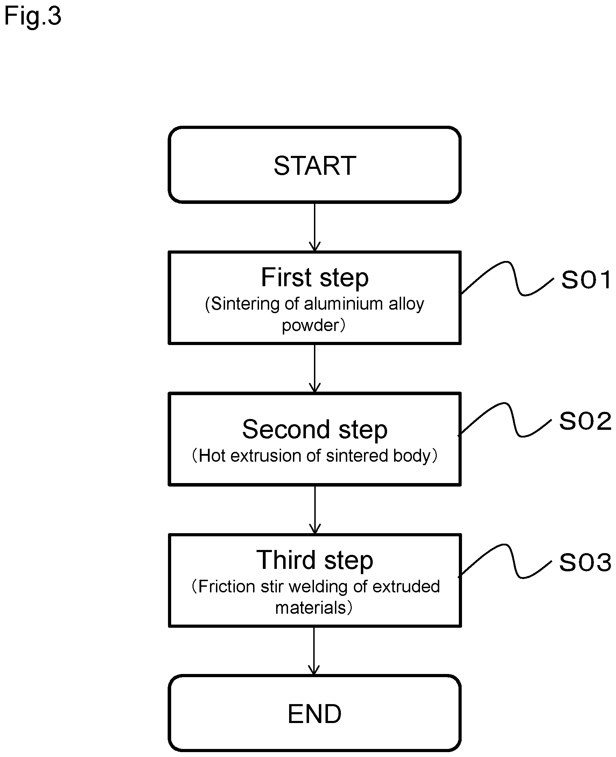

Fig. 3 shows a process flow of a method of manufacturing a pellicle frame for FPD (flat panel display) of the present invention. Method for producing a pellicle frame for FPD (flat panel display) of the present invention includes a first step of obtaining an aluminum alloy powder sintered body by sintering the aluminum alloy powder (S01), a second step of extruding the aluminum alloy powder sintered body to obtain an extruded material (S02), and a third step of friction stir welding the extruded materials to each other to obtain a frame (S3). Hereinafter, each process, etc. will be described in detail.

### (1) First step (S01: sintering of aluminum alloy powder)

The first step (S01) is a step of sintering the aluminum alloy powder in order to obtain an extruded material 2 in the second step (S02). Here, the aluminum alloy powder contains Si:20 to 40 % by mass, Mg:0.2 to 1.2 % by mass, Cu:2 % by mass or less, Fe:2 % by mass or less, Cr:0.4 % by mass or less, the balance being Al and unavoidable impurities.

It is preferable that the aluminum alloy powder is premolded. The method of premolding is not particularly limited as long as the effect of the present invention is not impaired, and can be performed by various methods known in the art and, for example, a press method, a CIP method, or the like can be used. Incidentally, the molding pressure of the premolding can be appropriately set in accordance with the composition, the shape, the particle size and the like of the aluminum alloy powder.

As the conditions for sintering the premolded body, a sintering conditions can be used such that a good sintered body which can give an extruded material having a good state by hot extrusion by appropriately controlling the composition, the particle size, the shape and the like of the aluminum alloy powder and the density or the like of the premolded body. As the sintering conditions, for example, after holding the premolded body for 0.5 to 2 hours in a vacuum furnace in which the inner furnace temperature is controlled to 100 to 400 ° C at a vacuum degree of 1Torr or less, and while keeping the vacuum degree 1Torr or less (preferably 0.0 1Torr or less), the the innner furnace temperature is raised such that the temperature of the premolded body becomes 520 to 570 ° C and held for 1 to 6 hours.

### (2) Second step (S02: hot extrusion of the sintered body)

The second step (S02) is a step for obtaining the extruded material 2 by hot extrusion of the sintered body obtained in the first step (S01).

The method and conditions of the hot extrusion is not particularly limited to the extent that does not impair the effect of the present invention, and it is sufficient to use the hot extrusion method and conditions of the conventionally known aluminum alloy powder sintered body and set the temperature of the hot extrusion to about 400 to 500 ° C.

Further, when hot extrusion, a metal plate (e.g., pure aluminum or 5000 series aluminum alloy or the like) can be disposed facing the sintered body, which is an extruded material, in front of a molding die. Thus, it is possible to form a thin film having the composition of the metal plate on the surface of the extruded material 2, and it is possible to suppress the temporal pitting corrosion and total corrosion at the interface of Si and Al that may occur when Al-Si based material is on the outermost surface. Here, since the thin dissimilar alloy film present on the surface of the metal plate is entrained in the stirred portion by friction stir welding, it is preferable to remove the dissimilar alloy film from a region to be welded as a pretreatment of the friction stir welding.

The molded body obtained by the hot extrusion can be subjected to forging or the like to impart the desired shape, if necessary. In this case, prior to the forging or the like, it may be carried out heat treatment of the molded body. For example, by conducting a heat treatment of about 0.5 to 2 hours at 200 to 400 ° C, it is possible to enhance the forgeability of the molded body obtained by the hot extrusion.

### (3) Third step (S03: Friction stir welding of extruded material)

The third step (S03) is a step for obtaining a pellicle frame 1 for FPD (flat panel display) by friction stir welding the extruded material 2 to each other obtained in the second step (S02).

When welding the extruded material 2 to each other in melt welding such as laser welding, the welded portion becomes a rapidly solidified structure and its hardness is increased as compared with the region other than the welded portion in some cases. Further, since the amount of heat so as to melt the material is input, softening in the heat affected zone also becomes remarkable. Although these changes in local mechanical properties are undesirable with respect to the pellicle frame 1 for FPD (flat panel display), the use of friction stir welding, which is a solid-state welding, can reduce the difference in mechanical properties between the welded portion and other regions.

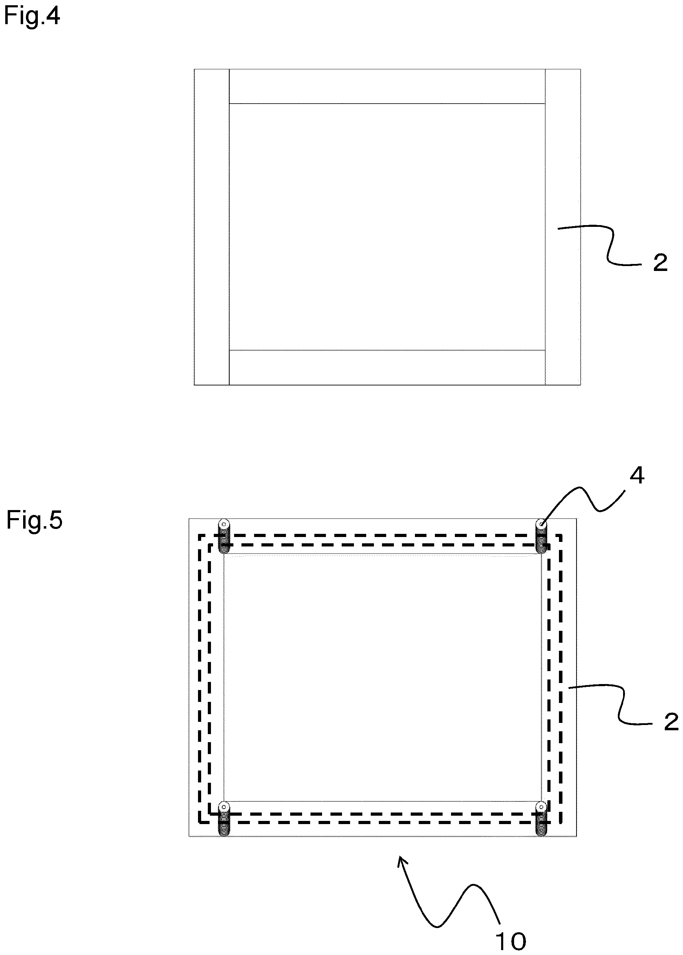

Fig. 4 shows an example of the arrangement of the extruded material 2 when subjected to friction stir welding. It is preferable to constitute a pellicle frame 1 for FPD (flat panel display) by using the extruded material 2 having substantially the same shape and size and integrating the four extruded material 2 by friction stir welding. By unifying the shape and size of the extruded material 2 constituting the pellicle frame 1 for FPD (flat panel display), it is possible to improve the workability of extrusion and friction stir welding and to reduce the manufacturing cost.

Fig. 5 shows a schematic diagram of a frame obtained by applying friction stir welding to the extruded material 2. Although the four extruded material 2 are integrated by the friction stir welded portions 4, a tool hole is formed on a welding edge in the general friction stir welding. In contrast, for example, by cutting both sides of the frame 10 with a dotted line shown in Fig. 5, it is possible to reliably obtain a pellicle frame 1 for FPD (flat panel display) that does not include a welding defect.

Further, it is preferable that the length of the short side of the frame 10 is 330 mm or more and the length of the long side of the frame 10 is 430 mm or more, after cutting process. Since the extruded material 2 of the aluminum alloy powder sintered body having a high Young's modulus are welded by friction stir welding which is a solid state welding, a good pellicle frame 1 for FPD (flat panel display) can be obtained even when the frame 10 is enlarged and its plate width is lowered after cutting process.

The method of friction stir welding is not particularly limited as long as it does not impair the effect of the present invention, and it is possible to use a variety of friction stir welding methods known conventionally, but it is preferable to conduct friction stir welding by positional control of a welding tool. By using the positional control, it is possible to accurately control the position (depth) of the welded portion (stirred portion). In the pellicle frame 1 for FPD (flat panel display), although the formation of the unwelded portion in the rear surface of the welded portion becomes a serious problem, it is possible to completely suppress the formation of the unwelded portion by appropriately performing friction stir welding using the positional control.

Although representative embodiments of the present invention have been described above, the present invention is not limited to these, and various design modifications are possible, and all of these design modifications are included in the technical scope of the present invention.

### EXAMPLE

### <<Examples>>

An aluminum alloy powder having a composition of Si:27%, Fe:0.25%, Cu:0.25%, Mg:0.7%, Cr:0.15% was sintered by holding in a vacuum atmosphere for 4 hours at 565 ° after CIP-molding. The sintered body had a bulk density of 2.3 g/cm³ and an outer diameter of 250mm (first step). Incidentally, the particle size of 93 % of the aluminum alloy powder used as a raw material is less than 150 µm (low tap method).

Next, the obtained sintered body was subjected to hot extrusion as a billet for hot extrusion. Specifically, the billet was heated at 450 ° C and inserted into a container of 10 inch extruder to heated at 450 ° C obtain a plate-shaped extruded material having a width of 100 mm and the thickness of 8 mm by extrusion molding (second step).

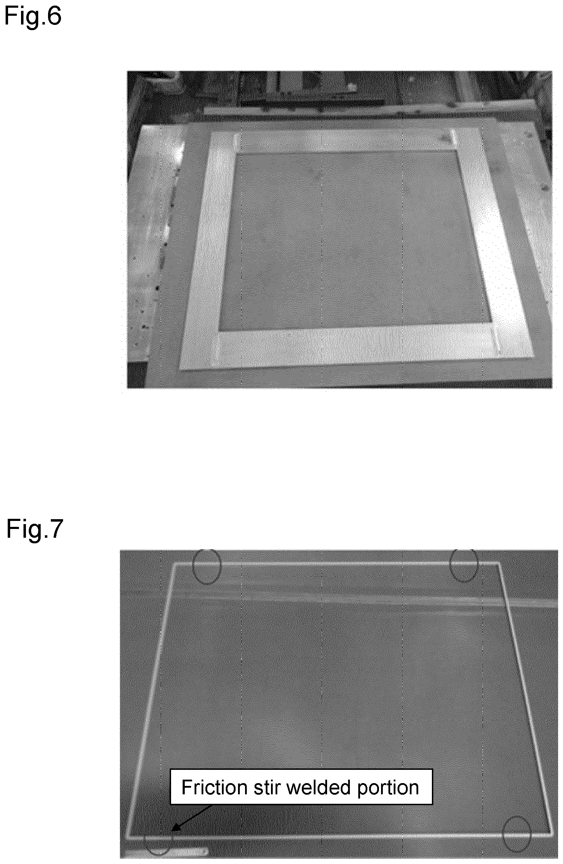

Then, four extruded materials were arranged in the state shown in Fig. 4 and friction stir welded to each other to obtain a frame shown in Fig. 5 (third step). Incidentally, by using a dedicated friction stir welding apparatus for welding and conducting friction stir welding by positional control of the tool, defect-free welded portions were formed in the butt region of the extruded materials facing each other (pull-out holes of the tool remains in the welding edge portions). A photograph of the frame after friction stir welding is shown in Fig. 6.

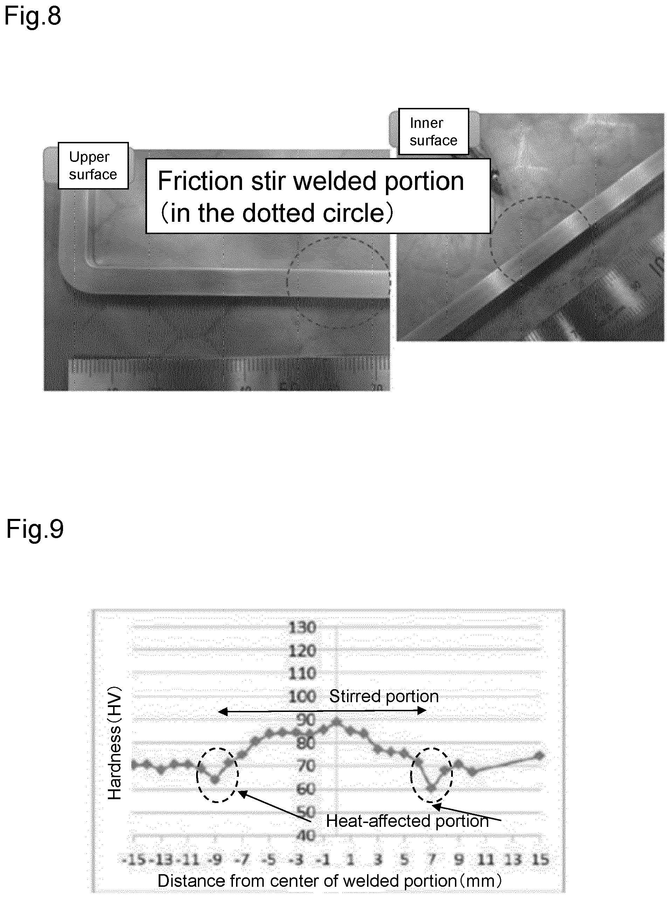

Next, by cutting the resulting frame body, a pellicle frame for FPD (flat panel display) having a long side of 940 mm and a short side of 760 mm, a frame width of 6 mm and a frame thickness of 6 mm was obtained. An overview photograph of the obtained pellicle frame for FPD (flat panel display) is shown in Fig. 7. No distortion, etc. was observed in the FPD (flat panel display) pellicle frame body, and the appropriate pellicle frame body for the FPD (flat panel display) has been obtained. An enlarged photograph of the friction stir welded portion of the pellicle frame for the FPD (flat panel display) is shown in Fig. 8. The friction stir welded portions and other regions have no difference in the degree to which any discrimination is difficult at first glance, and a pellicle frame body for FPD (flat panel display) which is extremely homogeneous in appearance is obtained.

The material used for the obtained pellicle frame for FPD (flat panel display) was subjected to tensile test to obtain Young's modulus from the stress-strain curve, and it was 89 GPa. The Young's modulus of the material used for the pellicle frame for FPD (flat panel display) made of A5052 aluminum alloy, which is known in the art, is about 69 GPa and it is understood that the material used for the obtained pellicle frame for FPD (flat panel display) has a high Young's modulus. For the conditions of the tensile test, the crosshead displacement speed was set to 0.5 mm/min until Young's modulus and proof stress measurements and was set to 5 mm/min after these measurements.

The hardness distribution in the horizontal direction of the welded portions of the pellicle frame for FPD (flat panel display) is shown in Fig. 9. Incidentally, the welded portion was cut perpendicular to the longitudinal direction of the frame and the hardness distribution was measured in the horizontal direction at the center of the plate thickness. It is recognized that the increase of hardness due to microstructure refinement in the welded portion (stirred portion) and the decrease of hardness due to thermal effects on the outside of the welded portion (stirred portion), but these hardness increases and hardness decreases are not remarkable in the range of 70 to 130 % of the base material.

### <<Comparative example>>

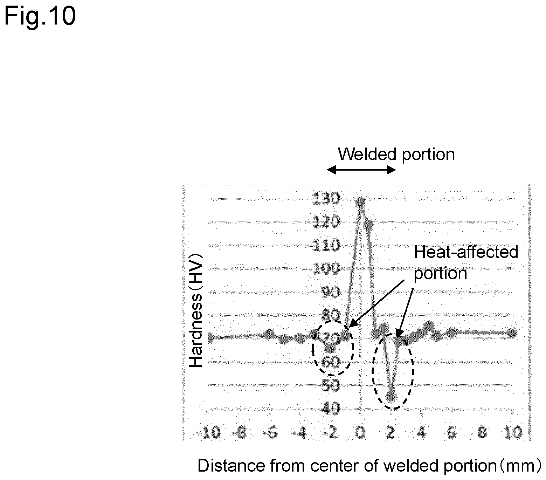

A pellicle frame for FPD (flat panel display) was obtained in the same manner as in Example except that laser welding was used for welding the extruded materials to each other. Further, in the same manner as in Example, the hardness distribution of the laser welded portion was measured. The results obtained are shown in Fig. 10.

A remarkable hardness increase was observed in the laser welded portion composed of a rapidly solidified structure, and the hardness decrease in the heat affected zone was also large. Due to the difference in mechanical properties at the welded portions and the other regions, the decrease in dimensional accuracy and long-term reliability is particularly remarkable in the pellicle frame for FPD (flat panel display) and it is difficult to use a laser welding for the welding of the aluminum alloy powder extruded materials.

### EXPLANATION OF NUMERALS

- 1: pellicle frame for FPD (flat panel display)
- 2: extruded material
- 4: friction stir welded portion
- 10: frame

## Claims

1. A pellicle frame for FPD (flat panel display) comprising an extruded materials of an aluminum alloy powder (or powder sintered body), which contains Si:20 to 40 % by mass, Mg:0.2 to 1.2 % by mass, Cu:2 % by mass or less, Fe:2 % by mass or less, Cr:0.4 % by mass or less, the balance being Al and unavoidable impurities.

2. The pellicle frame for FPD (flat panel display) in accordance with Claim 1, wherein the extruded materials are integrated with each other by friction stir welded portion.

3. The pellicle frame for FPD (flat panel display) in accordance with Claim 1 or 2, wherein the Young's modulus of materials used for the frame is 80 GPa or higher.

4. The pellicle frame for FPD (flat panel display) in accordance with any one of Claims 1 to 3, wherein the length of the short side is 330 mm or more and the length of the long side is 430 mm or more.

5. The pellicle frame for an FPD (flat panel display) in accordance with any one of Claims 1 to 4, wherein the frame is composed of four of the extruded materials having substantially the same shape and size.

6. A method of manufacturing a pellicle frame for FPD (flat panel display) comprising;
a first step of sintering an aluminum alloy powder containing Si:20 to 40 % by mass, Mg:0.2 to 1.2 % by mass, Cu:2 % by mass or less, Fe:2 % by mass or less, Cr:0.4 % by mass or less, the balance being Al and unavoidable impurities to obtain an aluminum alloy powder sintered body,
a second step of extruding the aluminum alloy powder sintered body to obtain an extruded material, and
a third step of friction stir welding the extruded materials with each other to obtain a frame.

7. The method of manufacturing a pellicle frame for FPD (flat panel display) in accordance with Claim 6, wherein the frame is subjected to cutting process.

8. The method of manufacturing a pellicle frame for FPD (flat panel display) in accordance with Claim 6 or 7, wherein the length of the short side of the frame is 330 mm or more and the length of the long side 430 mm or more after cutting process.

9. The method of manufacturing a pellicle frame for FPD (flat panel display) in accordance with any one of Claims 6 to 8, wherein in the third step, the frame is constituted with four of the extruded materials having substantially the same shape and size.

10. The method of manufacturing a pellicle frame for FPD (flat panel display) in accordance with any one of Claims 6 to 9, wherein the friction stir welding is conducted by a positional control of a welding tool.
